(19) Europäisches Patentamt
European Patent Office
Office européen des brevets

(11) EP 1 635 219 B1

# (12) EUROPEAN PATENT SPECIFICATION

(45) Date of publication and mention of the grant of the patent:
**05.05.2010 Bulletin 2010/18**

(51) Int Cl.:
***G03F 7/027*** *(2006.01)*

(21) Application number: **05018475.3**

(22) Date of filing: **25.08.2005**

## (54) Photosensitive lithographic printing plate

Lichtempfindliche Flachdruckplatte

Plaque d'impression lithographique photosensible

(84) Designated Contracting States:
**AT BE BG CH CY CZ DE DK EE ES FI FR GB GR HU IE IS IT LI LT LU LV MC NL PL PT RO SE SI SK TR**

(30) Priority: **27.08.2004 JP 2004248622**

(43) Date of publication of application:
**15.03.2006 Bulletin 2006/11**

(73) Proprietor: **FUJIFILM Corporation**
**Minato-ku**
**Tokyo (JP)**

(72) Inventor: **Kondo, Shunichi,**
**Fuji Photo Film Co., Ltd**
**Haibara-gun**
**Shizuoka (JP)**

(74) Representative: **HOFFMANN EITLE**
**Patent- und Rechtsanwälte**
**Arabellastrasse 4**
**81925 München (DE)**

(56) References cited:
**EP-A- 0 807 853**
**EP-A- 1 148 387**
**US-A- 5 738 971**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

### FIELD OF THE INVENTION

The present invention relates to a photosensitive lithographic printing plate utilizing a photopolymerizable composition. In particular, the invention relates to a photosensitive lithographic printing plate for direct image drawing with high image quality, which is low in temperature dependency at the time of laser exposure.

### BACKGROUND OF THE INVENTION

In general, in a negative working photosensitive lithographic printing plate, the image formation is carried out in a process for coating a photosensitive composition on a support such as a roughed aluminum plate, exposing a desired image, polymerizing or crosslinking an image area (light-irradiated portion) to insolubilize it in a developing solution, and eluting a non-image area with the developing solution. Photopolymerizable compositions have hitherto been well known as the photosensitive composition to be used for such a purpose.

In recent years, the digitalizing technology for electronic processing, accumulating and outputting of image information by using a computer has become widespread. For example, the CTP (computer-to-plate) technology for scanning light having high directivity such as laser beams according to digitalized image information and directly producing a printing plate without using a lith film is desired, and printing plate precursors with high sensitivity adaptive therewith have been developed.

As a light source thereof, an Ar ion laser (488 nm) or an FD-YAG laser (532 nm) is used, and photosensitive lithographic printing plates having a photopolymerizable photosensitive layer adaptive therewith have been developed and put into practical use. Furthermore, recently, an InGaN based semiconductor laser (violet laser, 350 nm to 450 nm) is developed and expected to realize processing in a bright room, low costs of an exposing machine, and high productivity. Therefore, the development of a lithographic printing plate having a photopolymerizable photosensitive layer with high sensitivity, which has sensitivity to this light source, has become rapid. For example, a composition containing a combined initiation system of a titanocene and a coumarin dye as described in JP-A-9-268185 and JP-A-10-204085 and a composition containing a combined initiation system of a styryl based dye and a titanocene as described in JP-A-9-80750 are known as a photopolymerizable composition sensitive to the Ar ion laser or FD-YAG laser; and a photopolymerizable composition containing a carbazolylstyryl dye as described in JP-A-2001-42524 is known as a photopolymerizable composition sensitive to the violet laser.

In the case where such a photopolymerizable composition is applied as a lithographic printing plate, the photopolymerizable composition is usually used in the state that a photopolymerizable photosensitive layer containing the photopolymerizable composition is provided on a support and an oxygen-blocking layer made of polyvinyl alcohol, etc. is further provided thereon for the purpose of preventing oxygen which likely hinders the polymerization. According to JP-A-9-268185, JP-A-10-204085, JP-A-9-80750 and JP-A-2001-42524, though it has become possible to obtain a sharp relief image with high sensitivity, there is encountered a problem that the sensitivity differs depending upon the temperature at the time of exposure. In particular, in the case of preparing a halftone dot image with high definition having 175 lines or more or a halftone dot image using an FM screen of density modulation which has made tremendous progress recently, when image drawing is continuously performed by using an exposing machine, the temperature in the exposure atmosphere increases so that an image of a certain area is not obtained. Therefore, the development of a plate material which is low in temperature dependency has been required.

### SUMMARY OF THE INVENTION

Accordingly, a problem of the invention is to provide a photosensitive lithographic printing plate from which high sensitivity and high image quality are obtained. In more detail, a problem of the invention is to provide a lithographic printing plate for direct image drawing with high sensitivity and high image quality, which is low in temperature dependency at the time of exposure.

The present inventor thought that for the sake of making the temperature dependency at the time of exposure of a lithographic printing plate provided with a photopolymerizable photosensitive layer low, a method for accelerating polymerization reaction in the photosensitive layer is effective and made extensive and intensive investigations regarding the chemical structure and content of an ethylenically unsaturated group-containing compound, the chemical structure and molecular weight of a binder, and so on. As a result, it has been found that when an ethylenically unsaturated group-containing compound having a specific structure is contained, a photosensitive lithographic printing plate with high sensitivity, which is low in temperature dependency at the time of exposure, leading to accomplishment of the invention.

That is, the foregoing problem can be achieved by the following photosensitive lithographic printing plates (1) and (2).

(1) A photosensitive lithographic printing plate comprising an aluminum support subjected to a roughing treatment and having thereon a photopolymerizable photosensitive layer, wherein the photopolymerizable photosensitive layer contains a compound containing three or more ethylenically unsaturated double bonds and containing 4 to 12 structural units selected from an ethyleneoxy structural unit and a propyleneoxy structural unit in one molecule thereof, an alkali-soluble or swelling binder, and a photopolymerization initiator.
(2) The photosensitive lithographic printing plate as set forth above in (1), wherein the photopolymerizable photosensitive layer further contains a compound selected from acrylates and methacrylates each containing three or more ethylenically unsaturated groups in one molecule thereof and having a molecular weight of not more than 800.
(3) The photosensitive lithographic printing plate as set forth above in (1) or (2), wherein the alkali-soluble or swelling binder contains a radical reactive group in the side chain thereof.

DETAILED DESCRIPTION OF THE INVENTION

The photosensitive lithographic printing plate of the invention will be hereunder described in detail.
The photosensitive lithographic printing plate of the invention has a photopolymerizable photosensitive layer on a support. Furthermore, if desired, an undercoat layer may be provided between the support and the photopolymerizable photosensitive layer, and a protective layer (oxygen-blocking layer) may be provided on the photopolymerizable photosensitive layer.

<1Support>

The lithographic printing plate comprises an aluminum substrate.
In order to obtain a lithographic printing plate which is one of the principal objects of the invention, it is desired to provide the foregoing photosensitive layer on a support the surface of which is hydrophilic. As the hydrophilic support, hydrophilic supports which have been conventionally known and used in a lithographic printing plate can be used without limitations. It is preferable that the support to be used is a dimensionally stable plate-like material. Examples thereof include plates of aluminum, and papers or plastic films laminated or vapor deposited with aluminum. The surface of such a material is subjected to a proper known physical or chemical treatment for the purposes of imparting hydrophilicity, enhancing the strength, etc.
In particular, aluminum plates are preferable as the support. Above all, aluminum plates which are dimensionally stable and relatively cheap and are able to provide a surface having excellent hydrophilicity and strength by the surface treatment as the need arises are especially preferable. A composite sheet in which an aluminum sheet is bound on a polyethylene terephthalate film as described in JP-B-48-18327 is also preferable.
The aluminum substrate is a metal plate containing dimensionally stable aluminum as the major component and is selected among not only pure aluminum plates but also alloy plates containing aluminum as the major component and a slight amount of foreign elements or plastic films or papers laminated or vapor deposited with aluminum (or an aluminum alloy).
In the following description, the foregoing substrate made of aluminum or an aluminum alloy will be generically named as "aluminum substrate". Examples of foreign elements which are contained in the foregoing aluminum alloy include silicon, iron, manganese, copper, magnesium, chromium, zinc, bismuth, nickel, and titanium. The content of foreign elements in the alloy is not more than 10 % by weight. While the pure aluminum plate which is suitable in the invention, since it is difficult to produce completely pure aluminum according to the smelting technology, a slight amount of foreign elements may be contained.
The aluminum plate which is applied in this way in the invention is not specified with respect to its composition, but raw materials which have hitherto been known and publicly used, for example, JIS A 1050, JIS A 1100, JIS A 3103, and JIS A 3005 can be properly utilized. Furthermore, the thickness of the aluminum substrate which is used in the invention is from about 0.1 mm to 0.6 mm, preferably from 0.15 mm to 0.4 mm, and especially preferably from 0.2 mm to 0.3 mm. This thickness can be properly changed depending upon the size of a printing machine, the size of a printing plate, and the desire of a user. The aluminum substrate is properly subjected to a substrate surface treatment as described later.

[Roughing treatment]

The aluminum substrate is subjected to a roughing treatment. The roughing treatment includes mechanical roughing, chemical etching, and electrolytic graining as disclosed in JP-A-56-28893. In addition, an electrochemical graining method for performing electrochemical roughing in a hydrochloric acid or nitric acid electrolytic liquid and a mechanical graining method such as a wire brush graining method for scratching the aluminum surface by a metallic wire, a ball graining method for graining the aluminum surface by an abrasive ball and an abrasive material, and a brush

roughing method for graining the surface by a nylon brush and an abrasive material are employable. The foregoing graining methods can be carried out singly or in combination. Above all, the method which is usefully employed for performing roughing is an electrochemical method for performing chemical graining in a hydrochloric acid or nitric acid electrolytic liquid, and a suitable quantity of electricity at the time of anode is in the range of from 50 c/dm$^2$ to 400 c/dm$^2$. More specifically, it is preferable that direct current or alternating current electrolysis is carried out in an electrolytic liquid containing from 0.1 to 50 % of hydrochloric acid or nitric acid under conditions at a temperature of from 20 to 100 °C for a period of time of from one second to 30 minutes and at a current density of from 100 c/dm$^2$ to 400 c/dm$^2$.

The thus roughed aluminum substrate may be chemically etched with an acid or an alkali. Examples of an etchant which is suitably used include sodium hydroxide, sodium carbonate, sodium aluminate, sodium metasilicate, sodium phosphate, potassium hydroxide, and lithium hydroxide. Preferred ranges of the concentration and temperature are from 1 to 50 % and from 20 to 100 °C, respectively. After the etching, for the purpose of removing smuts remaining on the surface, acid washing is carried out. Examples of the acid to be used include nitric acid, sulfuric acid, phosphoric acid, chromic acid, hydrofluoric acid, and borofluoric acid. In particular, as the method for removing smuts after the electrochemical roughing treatment, a method for bringing it into contact with sulfuric acid of from 15 to 65 % by weight at a temperature of from 50 to 90 °C as described in JP-A-53-12739 and an alkaline etching method as described in JP-B-48-28123 are preferable. There are no particular limitations regarding the method and conditions so far as after the treatment, the treated surface has a center line average roughness (Ra) of from 0.2 to 0.5 μm.

[Anodic oxidation treatment]

The thus roughed aluminum substrate is then subjected to an anodic oxidation treatment to form an oxidized film having been subjected to an anodic oxidation treatment. The anodic oxidation treatment is carried out in an electrolytic bath containing as the major component one or two or more kinds of aqueous solutions of sulfuric acid, phosphoric acid, oxalic acid, or boric acid/sodium borate. On this occasion, the electrolytic liquid may contain at least components which are usually contained in an Al alloy plate, an electrode, tap water and underground water. In addition, the second or third component may be contained. Examples of the second or third component as referred to herein include cations such as ions of metals (for example, Na, K, Mg, Li, Ca, Ti, Al, V, Cr, Mn, Fe, Co, Ni, Cu, and Zn) and an ammonium ion; and anions such as a nitric acid ion, a carbonic acid ion, a chlorine ion, a phosphoric acid ion, a fluorine ion, a sulfurous acid ion, a titanic acid ion, a silicic acid, and a boric acid ion. The second or third component may be contained in a concentration of from approximately 0 to 10,000 ppm. Though the anodic oxidation treatment is not particularly limited regarding its conditions, it is preferably carried out in a concentration in the range of from 30 to 500 g/liter at a treating liquid temperature in the range of from 10 to 70 °C in a current density in the range of from 0.1 to 40 A/m$^2$ by means of direct current or alternating current electrolysis. The thickness of the formed anodically oxidized film is in the range o from 0.5 to 1.5 μm, and preferably in the range of from 0.5 to 1.0 μm.

In addition, a substrate which, after these treatments, has been undercoated with a water-soluble resin (for example, polyvinylphosphonic acid, polymers or copolymers containing a sulfonic acid group in the side chain thereof, and polyacrylic acid), a water-soluble metal salt (for example, zinc borate), a yellow dye, an amine salt, etc., is also suitable. In addition, a substrate which has been subjected to a sol-gel treatment having a functional group capable of causing addition reaction by a radical covalent bonded thereto as disclosed in JP-A-7-159983 is also suitably used.

As other preferred examples, there are enumerated substrates in which a waterproof hydrophilic layer is provided as a surface layer on an arbitrary support. Examples of such a surface layer include layers comprising an inorganic pigment and a binder as described in U.S. Patent No. 3,055,295 and JP-A-56-13168, hydrophilic swelling layers as described in JP-A-9-80744, and sol-gel films comprising titanium oxide, polyvinyl alcohol and a silicic acid as described in JP-T-8-507727. Besides the purpose of making the surface of the support hydrophilic, such a hydrophilic treatment is carried out for the purposes of preventing a noxious reaction of the photopolymerizable composition to be provided thereon and enhancing adhesion of the photosensitive layer.

<2. Undercoat layer>

It is possible to provide an undercoat layer made of a water-soluble (for example, polyvinylphosphonic acid, polymers or copolymers containing a sulfonic acid group in the side chain thereof (as described in JP-A-59-101651), and polyacrylic acid), a water-soluble metal salt (for example, zinc borate), a yellow dye, an amine salt, etc. on the foregoing support. In addition, a substrate which has been subjected to a sol-gel treatment having a functional group capable of causing addition reaction by a radical covalent bonded thereto as disclosed in JP-A-7-159983 is also suitably used.

As other preferred examples, there are enumerated substrates in which an undercoat layer containing an onium group is provided as described in JP-A-2003-021908 and substrates in which a waterproof hydrophilic layer is provided as a surface layer on an arbitrary support. Examples of such a surface layer include layers comprising an inorganic

pigment and a binder as described in U.S. Patent No. 3,055,295 and JP-A-56-13168, hydrophilic swelling layers as described in JP-A-9-80744, and sol-gel films comprising titanium oxide, polyvinyl alcohol and a silicic acid as described in JP-T-8-507727. Besides the purpose of making the surface of the support hydrophilic, such a hydrophilic treatment is carried out for the purposes of preventing a noxious reaction of the photopolymerizable composition to be provided thereon and enhancing adhesion of the photosensitive layer.

The amount of the undercoat layer to be applied is in general from 0.5 to 500 mg/m$^2$, and preferably from 1 to 100 mg/m$^2$ on a dry weight basis.

<3. Photopolymerizable photosensitive layer>

The photopolymerizable composition for applying a photopolymerizable photosensitive layer of the photosensitive lithographic printing plate of the invention contains, as essential components, a compound containing three or more ethylenically unsaturated double bonds and containing four or more structural units selected from an ethyleneoxy structural unit and a propyleneoxy structural unit in one molecule thereof (hereinafter sometimes referred to as "ethylenically unsaturated bond-containing compound (a)"), an alkali-soluble or swelling binder, and a photopolymerization initiator. If desired, a variety of compounds such as a coloring agent, a plasticizer, and a thermal polymerization inhibitor can be used jointly.

(A. Ethylenically unsaturated bond-containing compound (a) >

The invention is characterized by containing (a) a compound containing three or more ethylenically unsaturated double bonds and containing four or more structural units selected from an ethyleneoxy structural unit and a propyleneoxy structural unit in one molecule thereof (ethylenically unsaturated bond-containing compound (a)) as an ethylenically unsaturated bond-containing compound. In order to obtain a hardened film with high sensitivity and high printing resistance, since it may be considered that a compound in which ethylenically unsaturated bonds are densely crammed in one molecule thereof is useful from the viewpoints of enhancement of a reaction probability and a crosslinking density, the present inventor studied these compounds. As a result, it has become possible to obtain a sharp relief image with high sensitivity in many compounds. Among them, it has been found that when the unsaturated group-containing compound of the invention is used, not only high sensitivity is obtained, but also the temperature dependency at the time of exposure becomes remarkably low.

Reasons why these characteristic features are revealed are not always elucidated. However, it is possible to presume that when a number of ethyleneoxy structural units and/or propyleneoxy structural units are contained in the molecule of the ethylenically unsaturated-containing compound, Tg of the polymerizable photosensitive layer is dropped and a free volume of the reaction system increases so that the polymerization reaction proceeds even at a low temperature; and that since hydrogen atoms in the ethyleneoxy structural units and/or propyleneoxy structural units are liable to cause crosslinking due to a hydrogen abstraction reaction by polymerizable radicals, not only high sensitivity is obtained, but also the temperature dependency becomes low.

The ethylenically unsaturated bond-containing compound (a) contains from 4 to 12 ethyleneoxy structural units and/or propyleneoxy structural units. Furthermore, the number of ethylenically unsaturated groups is preferably from 3 to 8.

The ethylenically unsaturated bond-containing compound (a) can be synthesized by, for example, an esterification reaction between every kind of a polyhydric alcohol containing an ethyleneoxy group or a propyleneoxy group and an unsaturated carboxylic acid (for example, acrylic acid, methacrylic acid, itaconic acid, crotonic acid, isocrotonic acid, and maleic acid) or an amidation reaction between every kind of an aliphatic polyhydric amine compound containing an ethyleneoxy group or a propyleneoxy group and the foregoing unsaturated carboxylic acid.

A molecular weight of the ethylenically unsaturated bond-containing compound (a) is in general from 274 to 1,500, and preferably from 400 to 1,000.

Specific examples of the compound will be given below as (a-1) to (a-20), but it should not be construed that the invention is limited thereto.

(a-1)

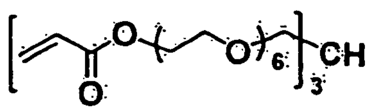

(a-2)

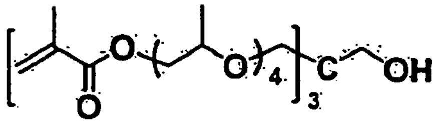

(a-3)

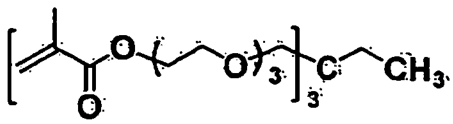

(a-4)

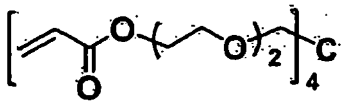

(a-5)

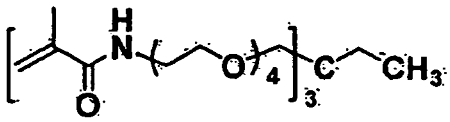

(a-6)

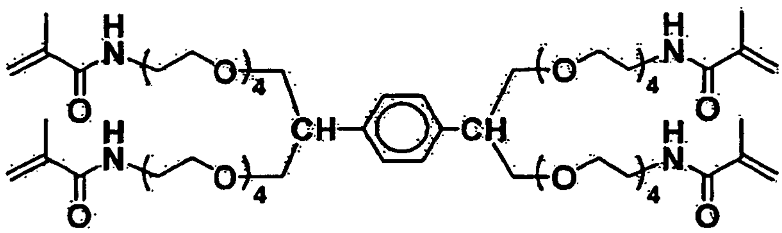

(a-7)

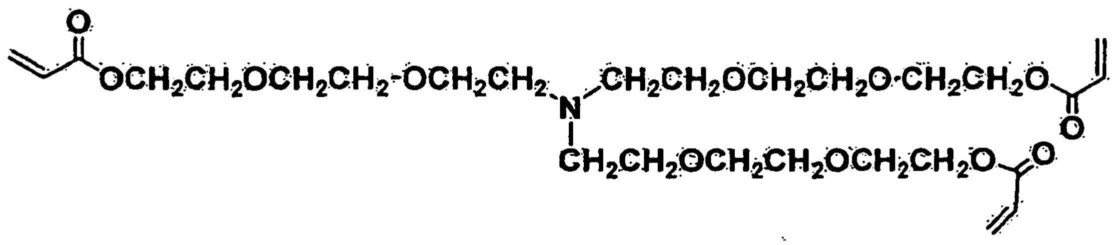

(a-8)

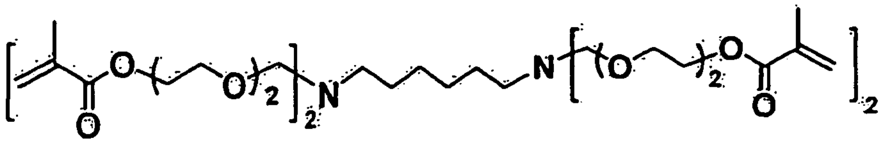

(a-9)

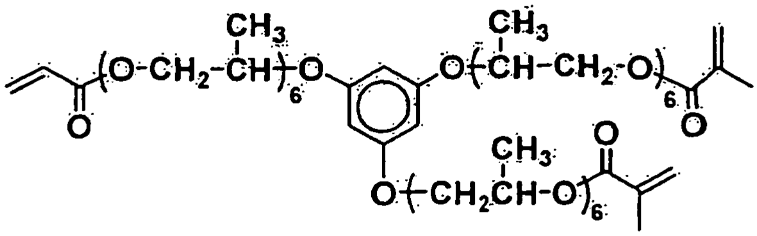

(a-10)

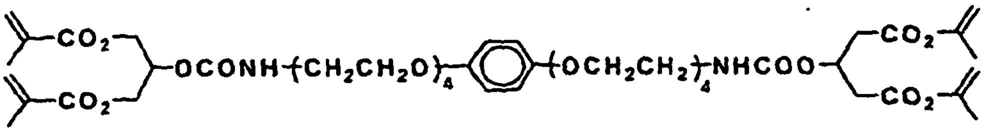

(a-11)

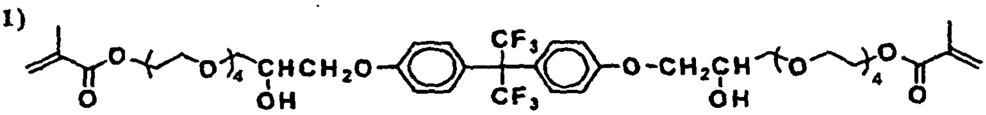

(a-12)

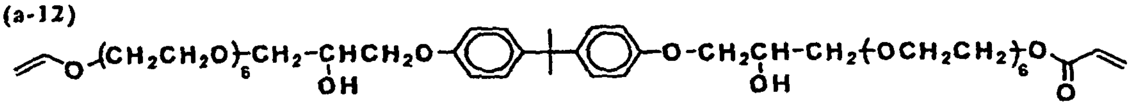

(a-13)

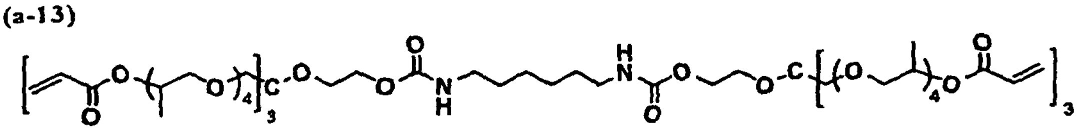

(a-14)

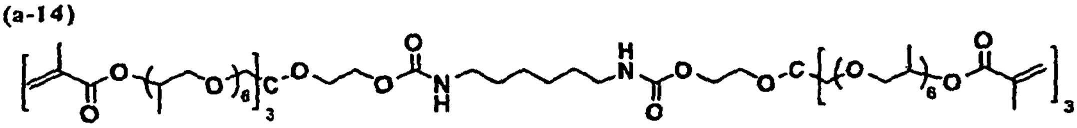

(a-15)

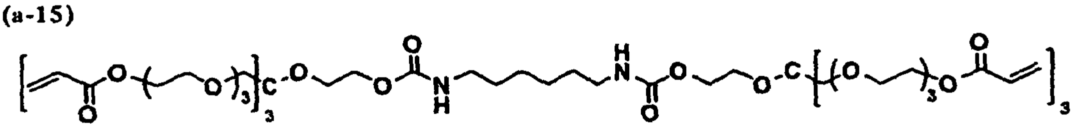

(a-16)

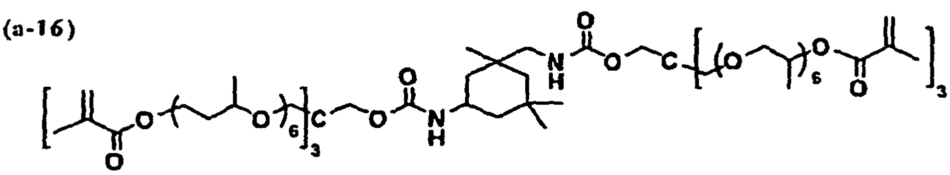

(a-17)

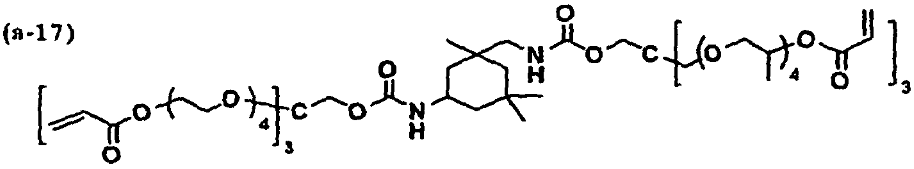

(a-18)

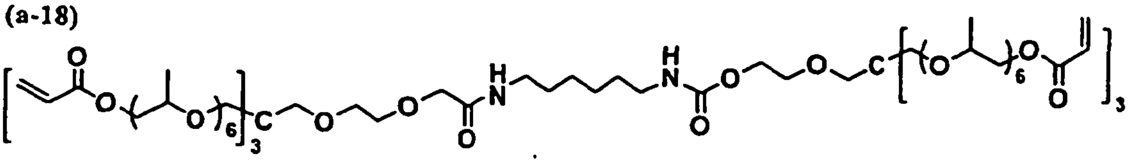

(a-19)

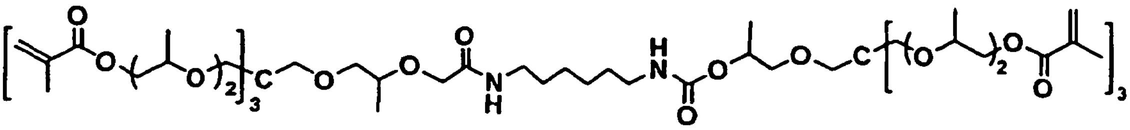

(a-20)

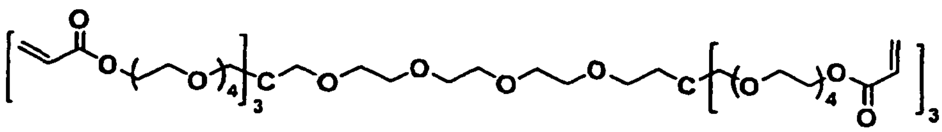

Furthermore, in the invention, for the purposes of further enhancing the sensitivity and adjusting flexibility of a photohardened film, it is preferred to use a compound selected from acrylates and methacrylates each containing three or more ethylenically unsaturated groups in one molecule thereof and having a molecular weight of not more than 800 (hereinafter sometimes referred to as "ethylenically unsaturated bond-containing compound (b)") jointly with the ethylenically unsaturated bond-containing compound (a). Examples of the ethylenically unsaturated bond-containing compound (b) include esters between the foregoing unsaturated carboxylic acid and an aliphatic polyhydric alcohol compound and amides between the foregoing unsaturated carboxylic acid and an aliphatic polyhydric amine.

A molecular weight of the ethylenically unsaturated bond-containing compound (b) is preferably from 267 to 800, and the number of ethylenically unsaturated groups is preferably from 3 to 8.

With respect to specific examples of the monomer of the ester between an aliphatic polyhydric alcohol compound and an unsaturated carboxylic acid, examples of acrylic esters include trimethylolpropane triacrylate, trimethylolpropane tri(acryloyloxypropyl) ether, trimethylolethane triacrylate, pentaerythritol triacrylate, pentaerythritol tetraacrylate, dipentaerythritol pentaacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, and polyester acrylate oligomers.

Examples of methacrylic esters include trimethylolpropane trimethacrylate, trimethylolpropane tri-(methacryloyloxypropyl) ether, trimethylolethane trimethacrylate, pentaerythritol trimethacrylate, pentaerythritol tetramethacrylate, dipentaerythritol pentamethacrylate, dipentaerythritol hexamethacrylate, sorbitol trimethacrylate, sorbitol tetramethacrylate, sorbitol pentamethacrylate, sorbitol hexamethacrylate, tri(methacryloyloxyethyl) cyanurate, and polyester methacrylate oligomers.

Examples of itaconic esters include trimethylolpropane triitaconate, pentaerythritol triitaconate, pentaerythritol tetetraitaconate, dipentaerythritol hexaitaconate, sorbitol triitaconate, and tri(itaconoyloxyethyl) isocyanurate.

Examples of crotonic esters include trimethylolpropane tricrotonate, pentaerythritol tricrotonate, pentaerythritol tetetracrotonate, dipentaerythritol hexacrotonate, sorbitol tricrotonate, and tri(crotonoyloxyethyl) isocyanurate.

Examples of isocrotonic esters include trimethylolpropane triisocrotonate, pentaerythritol triisocrotonate, pentaerythritol tetetraisocrotonate, dipentaerythritol hexaisocrotonate, sorbitol triisocrotonate, and tri(isocrotonoyloxyethyl)

isocyanurate.

Examples of maleic esters include trimethylolpropane trimaleate, pentaerythritol trimaleate, pentaerythritol tetramaleate, dipentaerythritol hexamaleate, sorbitol trimaleate, and tri(malenoyloxyethyl) isocyanurate.

Furthermore, specific examples of the monomer of the amide between an aliphatic polyhydric amine compound and an unsaturated carboxylic acid include diethylenetriamine trisacrylamide, diethylenetriamine trismethacrylamide, triethylenetetramine trisacrylamide, triethylenetetramine trismethacrylamide, triethylenetetramine tetraacrylamide, and triethylenetetramine tetramethacrylamide.

Other examples include vinyl urethane compounds containing three or more polymerizable vinyl groups in one molecule thereof, in which a hydroxyl group-containing vinyl monomer (for example, ethyloxy acrylic acid and ethyloxy methacrylic acid) is added to a polyisocyanate compound containing three or more isocyanate groups in one molecule thereof, as described in JP-B-48-41708.

Furthermore, among urethane acrylates as described in JP-A-51-37193 and JP-B-2-32293 and polyester acrylates as described in JP-A-48-64183, JP-B-49-43191 and JP-B-52-30490, trifunctional or polyfunctional acrylates having a molecular weight of not more than 800 can be chosen and used.

The ethylenically unsaturated bond-containing compound (a) is preferably used in an amount in the range of from 10 to 80 % by weight, and more preferably from 30 to 70 % by weight based on the whole of solids constituting the photopolymerizable photosensitive layer.

Furthermore, in the case where the ethylenically unsaturated bond-containing compounds (a) and (b) are used jointly, a preferred mixing ratio ((a) / (b)) is preferably in the range of from 9/1 to 2/8, and more preferably from 8/2 to 4/6 in terms of a weight ratio.

(B. Binder)

Since the binder which is used in the photopolymerizable composition of the invention is a binder which is soluble or swelling in alkaline water and must be not only used as a film forming agent but also dissolved in an alkaline developing solution, an organic high molecular polymer which is soluble or swelling in alkaline water is used. For example, when a water-soluble organic high molecular polymer is used as the subject organic high molecular polymer, water development becomes possible. Examples of such an organic high molecular polymer include addition polymers containing a carboxyl group in the side chain thereof, for example, ones as described in JP-A-59-44615, JP-B-54-34327, JP-B-58-12577, JP-B-54-25957, JP-A-54-92723, JP-A-59-53836, and JP-A-59-71048, namely methacrylic acid copolymers, acrylic acid copolymers, itaconic acid copolymers, crotonic acid copolymers, maleic acid copolymers, and partially esterified maleic acid copolymers.

There are also enumerated acidic cellulose derivatives containing a carboxyl group in the side chain thereof. Besides, there are enumerated ones obtained by adding a cyclic acid anhydride to an addition polymer containing a hydroxyl group. Of these, copolymers of [benzyl (meth) acrylate/ (meth) acrylic acid/optionally other addition polymerizable vinyl monomer] and copolymers of [allyl (meth)acrylate/(meth)acrylic acid/optionally other addition polymerizable vinyl monomer] are especially suitable. Besides, polyvinylpyrrolidone, and polyethylene oxide are useful as the water-soluble organic high molecular polymers. Alcohol-soluble polyamides, polyethers of 2,2-bis(4-hydroxyphenyl)propane and epichlorohydrin are also useful for the purpose of enhancing the strength of a hardened film.

Furthermore, acid group-containing urethane based binder polymers as described in JP-B-7-120040, JP-B-7-120041, JP-B-7-120042, JP-B-8-12424, JP-A-63-287944, JP-A-63-287947, JP-A-1-271741, and Japanese Patent Application No. 10-116232 are advantageous in view of printing resistance and low exposure aptitude because they have a very excellent strength.

In such an organic high molecular polymer, by introducing a radical reactive group into the side chain thereof, it is possible to enhance the strength of a hardened film. Examples of a functional group which can undergo addition polymerization reaction include an ethylenically unsaturated bond group, an amino group, and an epoxy group; examples of a functional group which can become a radical upon irradiation with light include a mercapto group, a thiol group, a halogen atom, a triazine structure, and an onium salt structure; and examples of a polar group include a carboxyl group and an imido group. Though as the foregoing functional group which can undergo addition polymerization reaction, ethylenically unsaturated bond groups such as an acrylic group, a methacrylic group, an allyl group, and a styryl group are especially preferable, a functional group selected from an amino group, a hydroxyl group, a phosphonic acid group, a phosphoric acid group, a carbamoyl group, an isocyanate group, an ureido group, an ureylene group, a sulfonic acid group, and an ammonio group is also useful.

In the invention, polymers containing a (meth)acrylic structural unit ((meth)acrylic binder) and polymers containing a urethane structural unit (urethane based binder) are especially preferable. For example, (meth)acrylic binders as described in JP-A-11-352691 and urethane based binders as described in JP-A-11-352691, JP-A-2001-228608, JP-A-2002-174907, JP-A-2003-270775, and JP-A-2003-270776 are suitably used.

For the purpose of maintaining the developability of the photosensitive layer, it is preferable that the binder has

suitable molecular weight and acid value. A high molecular polymer having a weight average molecular weight of from 5,000 to 300,000 and an acid value of from 20 to 200 meq/g is effectively used as the binder.

Such a binder can be mixed in an arbitrary amount in the composition of the invention. In particular, when the amount of the binder is not more than 90 % by weight, there are brought preferred results in view of strength of the image to be formed, etc. The amount of the binder is preferably from 10 to 90 % by weight, and more preferably from 30 to 80 % by weight. Also, a weight ratio of the photopolymerizable ethylenically unsaturated bond-containing compound to the binder is preferably in the range of from 1/9 to 9/1, more preferably in the range of from 2/8 to 8/2, and further preferably in the range of from 3/7 to 7/3.

(C. Photopolymerization initiator)

As the photopolymerization initiator which is contained in the photopolymerizable photosensitive layer, a variety of photoinitiators which are known in patent documents, literature references, etc. or combined systems of two or more kinds of photoinitiators (photoinitiation systems) can be properly chosen and used depending upon the wavelength of a light source to be used. Specific examples thereof will be enumerated below, but it should not be construed that the invention is limited thereto.

In the case of using visible rays of 400 nm or more, Ar lasers, second harmonics of semiconductor laser, or SHG-YAG lasers as a light source, a variety of photoinitiation systems are proposed, too. Examples thereof include certain kinds of photoreducible dyes, for example, Rose Bengale, eosine, and erythrosine, as described in U.S. Patent No. 2,850,445; and systems comprising a combination of a dye and an initiator, for example, a composite initiation system of a dye and an amine (as described in JP-B-44-20189), a combined system of a hexaaryl biimidazole, a radical generator and a dye (as described in JP-B-45-37377), a system of a hexaaryl biimidazole and a p-dialkylaminobenzylidene ketone (as described in JP-B-47-2528 and JP-A-54-155292), a system of a cyclic cis-α-dicarbonyl compound and a dye (as described in JP-A-48-84183), a system of a cyclic triazine and a merocyanine dye (as described in JP-A-54-151024), a system of 3-ketocoumarin and an activator (as described in JP-A-52-112681 and JP-A-58-15503), a system of a biimidazole, a styrene derivative and a thiol (as described in JP-A-59-140203), a system of an organic peroxide and a dye (as described in JP-A-59-1504, JP-A-59-140203, JP-A-59-189340, JP-A-62-174203, JP-B-62-1641, and U.S. Patent No. 4,766,055), a system of a dye and an active halogen compound (as described in JP-A-63-258903 and JP-A-2-63054), a system of a dye and a borate compound (as described in JP-A-62-143044, JP-A-62-150242, JP-A-64-13140, JP-A-64-13141, JP-A-64-13142, JP-A-64-13143, JP-A-64-13144, JP-A-64-17048, JP-A-1-229003, JP-A-1-298348, and JP-A-1-138204), a system of a rhodanine ring-containing dye and a radical generator (as described in JP-2-179643 and JP-A-2-244050), a system of a titanocene and a 3-ketocoumarin dye (as described in JP-A-63-221110), a system of a titanocene, a xanthene dye and an amino group or urethane group-containing addition polymerizable ethylenically unsaturated compound (as described in JP-A-4-221958 and JP-A-4-219756), a system of a titanocene and a specific merocyanine dye (as described in JP-A-6-295061), and a system of a titanocene and a benzopyran ring-containing dye (as described in JP-A-8-334897).

Furthermore, in recent years, a laser having a wavelength of from 400 to 410 nm (violet laser) is also developed, and a photoinitiation system exhibiting high sensitivity to a wavelength of not more than 450 nm, which is sensitive thereto, is also developed. Such a photoinitiation system is useful, too. Examples thereof include a cation dye/borate system (as described in JP-A-11-84647), a merocyanine dye/titanocene system (as described in JP-A-2000-147763), and a carbazole type dye/titanocene system (as described in JP-A-2001-42524) . In the invention, a system using a titanocene compound is especially preferable because it is excellent in view of sensitivity.

As the titanocene compound, a variety of titanocene compounds can be used. For example, the titanocene compound can be properly chosen and used among various titanocene compounds as described in JP-A-59-152396 and JP-A-61-151197. In addition, specific examples thereof include dicyclopentadienyl-Ti-dihcloride, dicyclopentadienyl-Ti-bisphenyl, dicyclopentadienyl-Ti-bis-2,3,4,5,6-pentafluorophen-1-yl, dicyclopentadienyl-Ti-bis-2,3,5,6-tetrafluorophen-1-yl, dicyclopentadienyl-Ti-bis-2,4,6-trifluorophen-1-yl, dicyclopentadienyl-Ti-bis-2,6-difluorophen-1-yl, dicyclopentadienyl-Ti-bis-2,4-difluorophen-1-yl, dimethylcyclopentadienyl-Ti-bis-2,3,4,5,6-pentafluorophen-1-yl, dimethylcyclopentadienyl-Ti-bis-2,6-difluorophen-1-yl, and dicyclopentadienyl-Ti-bis-2,6-difluoro-3-(pyl-1-yl)-phen-1-yl.

In addition, it is known that when a hydrogen-donating compound such as thiol compounds (for example, 2-mercaptobenzothiazole, 2-mercaptobenzimidazole, and 2-mercaptobenzoxazole) and amine compounds (for example, N-phenylglycine and N,N-dialkylamino aromatic alkyl esters) is added to the foregoing photoinitiator as the need arises, a photoinitiation ability can be further enhanced.

The photoinitiator (photoinitiation system) is generally used in an amount ranging from 0.05 to 100 parts by weight, preferably from 0.1 to 70 parts by weight, and more preferably from 0.2 to 50 parts by weight based on 100 parts by weight of the ethylenically unsaturated bond-containing compound.

(Other components and preparation method)

In the invention, in addition to the foregoing basic components, it is desired to add a small amount of a thermal polymerization inhibitor during the production or storage of the photosensitive composition which is used in the photopolymerization layer for the purpose of preventing unnecessary thermal polymerization of the polymerizable ethylenically unsaturated double bond-containing compound from occurring. Examples of a suitable thermal polymerization inhibitor include hydroquinone, p-methoxyphenol, di-t-butyl-p-cresol, pyrogallol, t-butyl chatecol, benzoquinone, 4,4'-thiobis (3-methyl-6-t-butylphenol), 2,2'-methylenebis-(4-methyl-6-t-butylphenol), N-nitrosophenylhydroxylamine cerous salt, and N-nitrosophenylhydroxylamine aluminum salt. The amount of addition of the thermal polymerization inhibitor is preferably from about 0.01 % by weight to about 5 % by weight of the whole of solids of the composition. If desired, for the purpose of preventing polymerization hindrance due to oxygen, a higher fatty acid derivative (for example, behenic acid and behenic amide) or the like may be added, thereby unevenly distributing it on the surface of the photopolymerizable photosensitive layer during a drying step to be carried out after coating. The amount of addition of the higher fatty acid derivative is preferably from about 0.5 % by weight to about 10 % by weight of the whole of solids of the composition.

Moreover, for the purpose of coloring the photopolymerizable photosensitive layer, a coloring agent may be added. Examples of the coloring agent include pigments (for example, phthalocyanine based pigments (for example, C.I. Pigment Blue 15:3, C.I. Pigment Blue 15:4, and C.I. Pigment Blue 15:6), azo based pigments, carbon black, and titanium oxide) and dyes (for example, Ethyl Violet, Crystal Violet, azo dyes, anthraquinone based dyes, and cyanine based dyes) . The amount of addition of the dye or pigment is preferably from about 0.5 % by weight to about 5 % by weight of the whole of the composition. In addition, for the purpose of improving physical properties of a hardened film, additives such as inorganic fillers and plasticizers (for example, dioctyl phthalate, dimethyl phthalate, and tricresyl phosphate) may be added. The amount of addition of such an additive is preferably not more than 10 % by weight of the whole of of solids of the composition (the whole of the composition).

In coating the photopolymerizable composition, it is dissolved in every kind of an organic solvent and then provided for use. Examples of the solvent to be used herein include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxyethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, γ-butyrolactone, methyl lactate, and ethyl lactate. These solvents can be used singly or in admixture. A concentration of solids in the coating solution is in general from 1 to 50 % by weight.

For the purpose of enhancing the quality of the coated surface, it is possible to add a surfactant in the photopolymerizable composition. Its coverage is preferably from about 0.1 $g/m^2$ to about 10 $g/m^2$, more preferably from 0.3 to 5 $g/m^2$, and further preferably from 0.5 to 3 $g/m^2$ in terms of a weight after drying.

<4. Protective layer>

In the photosensitive lithographic printing plate of the invention, since the exposure is usually carried out in the air, it is preferred to further provide a protective layer on the layer made of the photopolymerizable composition. The protective layer prevents mingling of low molecular compounds (for example, oxygen and basic substances) present in the air, which likely hinder the image forming reaction as generated by exposure in the photosensitive layer, into the photosensitive layer from occurring, thereby making it possible to achieve exposure in the air. Accordingly, the protective layer is desired to have such characteristics that it has low permeability of low molecular compounds such as oxygen; that it does not substantially hinder transmission of light to be used for exposure; that it has excellent adhesion to the photosensitive layer; and that it can be easily removed in a development step after exposure. Devices regarding such a protective layer have hitherto been made, and details thereof are described in U.S. Patent No. 3,458,311 and JP-A-55-49729.

As materials which can be used in the protective layer, for example, water-soluble high molecular compounds having relatively excellent crystallinity can be used. Specifically, there are known water-soluble polymers such as polyvinyl alcohol, polyvinylpyrrolidone, acidic celluloses, gelatin, gum arabic, and polyacrylic acid. Above all, what polyvinyl alcohol is used as the major component brings the most satisfactory results in view of basic characteristics such as oxygen-blocking properties and development eliminating properties. With respect to the polyvinyl alcohol which is used in the protective layer, so far as an unsubstituted vinyl alcohol unit for the purpose of having necessary oxygen-blocking properties and water solubility is contained, a part thereof may be substituted with an ester, an ether or an acetal. Similarly, a part of the polyvinyl alcohol may have other copolymerization component. As specific examples, there can

be enumerated polyvinyl alcohols which are hydrolyzed to an extent of from 71 to 100 % and which have a molecular weight in the range of from 300 to 2,400.

Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, and L-8, all of which are manufactured by Kuraray Co., Ltd.

Components (selection of PVA and use of an additive) and coating amount of the protective layer are chosen while taking into consideration oxygen-blocking properties and development eliminating properties and besides, fogging properties, adhesion and scratch resistance. In general, the higher the degree of hydrolysis of PVA to be used (the higher the content of the unsubstituted vinyl alcohol unit in the protective layer) or the thicker the film thickness, the higher the oxygen-blocking properties, and such is advantageous in view of the sensitivity. However, when the oxygen-blocking properties are extremely increased, an unnecessary polymerization reaction likely occurs at the time of production and at the time of unprocessed stock storage. Also, there is caused a problem that unnecessary fog or thickening of image lines is caused at the time of image exposure. Also, adhesion to an image area and scratch resistance are extremely important in handling a plate. That is, when a hydrophilic layer made of a water-soluble polymer is laminated on a lipophilic polymer layer, film separation likely occurs due to a shortage of adhesive strength, and the separated portion causes defects such as inferior film hardening due to polymerization hindrance of oxygen.

In contrast, there have been made various proposals for the purpose of improving adhesion between these two layers. For example, by mixing an acrylic emulsion, a water-insoluble polyvinylpyrrolidone-vinyl acetate copolymer, etc. in an amount of from 5 to 80 % by weight in a hydrophilic polymer made of polyvinyl alcohol and laminating the mixture on the polymer layer, sufficient adhesion is obtained. For the protective layer in the invention, any of the known technologies can be applied. The coating method of such a protective layer is described in detail in, for example, U.S. Patent No. 3,458,311 and JP-A-55-49729.

Moreover, it is possible to impart other function to the protective layer. For example, by adding a coloring agent to be used for exposure (for example, water-soluble dyes), which is excellent in transmission against light of from 350 nm to 450 nm and which can efficiently absorb light of 500 nm or more, it is possible to further increase safelight aptitude without causing a reduction of the sensitivity.

The coverage of the protective layer is generally from about 0.1 $g/m^2$ to about 15 $g/m^2$, and preferably from about 1.0 $g/m^2$ to about 5.0 $g/m^2$ in terms of a weight after drying.

<5. Plate making process>

The photosensitive lithographic printing plate of the invention is usually image exposed, and an unexposed area of the photosensitive layer is then removed with a developing solution to obtain an image.

Besides, as a plate making process of the photosensitive lithographic printing plate of the invention, the entire surface may be heated before exposure, during exposure or in the course of from exposure to development as the need arises. By such heating, the image forming reaction in the photosensitive layer is promoted, thereby giving rise to advantages such as enhancement of the sensitivity and printing resistance and stabilization of the sensitivity. Moreover, for the purpose of enhancing the image strength and printing resistance, it is also effective to carry out entire post-heating or entire exposure of an image after the development. Usually, it is preferable that the heating before the development is carried out under a mild condition at not higher than 150 °C. When the temperature is too high, there is caused such a problem that a non-image area is fogged, too. For the heating after the development, a very strong condition is applied. Usually, the heating after the development is carried out at a temperature in the range of from 200 to 500 °C. When the temperature is too low, a sufficient image strengthening action is not obtained, while when it is too high, there are caused problems such as deterioration of the support and thermal decomposition of an image area.

With respect to the exposure method of a scan exposure lithographic printing plate according to the invention, known methods can be employed without limitations. A desired wavelength of the light source is from 350 nm to 450 nm, and specifically, an InGaN based semiconductor laser is suitable. With respect to the exposure mechanism, any of an internal drum system, an external drum system, a flat bed system, and so on may be employed. Furthermore, when a highly water-soluble material is used as the photosensitive layer component, it is possible to make the material soluble in neutral water or weakly alkaline water. There is also employable a system in which after mounting a lithographic printing plate having such a construction on a printing machine, exposure and development are carried out on the machine.

Furthermore, as other exposure rays for the photopolymerizable composition according to the invention, there can be employed various mercury vapor lamps (for example, an extra-high pressure mercury vapor lamp, a high pressure mercury vapor lamp, a medium pressure mercury vapor lamp, and a low pressure mercury vapor lamp), chemical lamps, carbon arc lamps, xenon lamps, metal halide lamps, various laser lamps (for example, visible laser lamps and ultraviolet laser lamps), fluorescent lamps, tungsten lamps, and sunlight. As available laser light sources of from 350 nm to 450 nm, the following can be employed.

Examples of gas lasers include an Ar ion laser (364 nm, 351 nm, 10 mW to 1W), a Kr ion laser (356 nm, 351 nm, 10 mW to 1W), and an He-Cd laser (441 nm, 325 nm, 1 mW to 100 mW) ; and examples of solid lasers include a combination of {Nd:YAG($YVO_4$) and SHG crystal} x 2 (355 nm, 5 mW to 1 W) and a combination of Cr:LiSAF and SHG crystal (430 nm, 10 mW). Examples of semiconductor laser systems include a $KnobO_3$ ring resonator (430 nm, 30 mW), a combination of a waveguide type wavelength converting element and AlGaAs and InGaAs semiconductors (380 nm to 450 nm, 5mW to 100 mW), a combination of a waveguide type wavelength converting element and AlGaInP and AlGaAs semiconductors (300 nm to 350 nm, 5 mW to 100 mW), and an AlGaInN semiconductor laser (350 nm to 450 nm, 5 mW to 30 mW); and besides, examples of pulse lasers include an $N_2$ laser (337 nm, pulse: 0.1 to 10 mJ) and XeF (351 nm, pulse: 10 to 250 mJ). Of these, an AlGaInN semiconductor laser (commercially available InGaN based semiconductor laser: 400 nm to 410 nm, 5 to 30 mW) is especially suitable in view of wavelength characteristics and costs.

Also, as an exposure device of lithographic printing plate of the scan exposure system, examples of the exposure mechanism include an internal drum system, an external drum system, and a flat bed system. As a light source, among the foregoing light sources, ones which can achieve continuous oscillation can be preferably utilized. Actually, the following exposure devices are especially preferable with respect to the relationship between the sensitivity of the photographic material and the plate making time.

(1) An exposure device of single beam to triple beams using at least one gas laser or solid laser light source according to an internal drum system such that the total output becomes 20 mW or more.
(2) An exposure device of multi-beams (one to ten) using at least one of a semiconductor laser, a gas laser and a solid laser according to the flat bed system such that the total output becomes 20 mW or more.
(3) An exposure device of multi-beams (one to nine) using at least one of a semiconductor laser, a gas laser and a solid laser according to the external drum system such that the total output becomes 20 mW or more.
(4) An exposure device of multi-beams (ten or more) using at least one of a semiconductor laser and a solid laser according to the external drum system such that the total output becomes 20 mW or more.

In the foregoing laser direct drawing type lithographic printing plates, in general, the following equation (eq 1) is valid among the sensitivity X of photographic material ($J/cm^2$), the exposed area S of photographic material ($cm^2$), the power g per one laser light source (W), the number n of lasers, and the entire exposure time $\underline{t}$ (s).

$$X \cdot S = n \cdot q \cdot t \qquad \text{(eq 1)}$$

i) Case of an internal drum (single beam) system:

In general, the following equation (eq 2) is valid among the revolution number $\underline{f}$ of laser (radian/s), the sub-scanning length Lx of photographic material (cm), the resolution Z (dots/cm), and the entire exposure time $\underline{t}$ (s).

$$f \cdot Z \cdot t = Lx \qquad \text{(eq 2)}$$

ii) Case of an external drum (multi-beam) system:

In general, the following equation (eq 3) is valid among the revolution number F of drum (radian/s), the sub-scanning length Lx of photographic material (cm), the resolution Z (dots/cm), the entire exposure time $\underline{t}$ (s), and the number $\underline{n}$ of beams.

$$F \cdot Z \cdot n \cdot t = Lx \qquad \text{(eq 3)}$$

iii) Case of a flat bead (multi-beam) system:

In general, the following equation (eq 4) is valid among the revolution number H of polygon mirror (radian/s), the sub-scanning length Lx of photographic material (cm), the resolution Z (dots/cm), the entire exposure time $\underline{t}$ (s), and the number $\underline{n}$ of beams.

$$F \cdot Z \cdot n \cdot t = Lx \quad \text{(eq 4)}$$

By substituting the exposure conditions of a resolution as required in an actual printing plate (2,560 dpi), a plate size (A1/B1, sub-scanning length: 42 inches) and about 20 sheets per hour and the photosensitive characteristics of the photosensitive composition of the invention (photosensitive wavelength and sensitivity: about 0.1 mJ/cm$^2$) in the foregoing respective equations, it can be understood that in a photographic material using the photosensitive composition of the invention, a combination with the multi-beam exposure system using a laser having a total output of 20 mW or more is especially preferable. However, in the case of using a laser having a necessary and sufficient output (30 mW or more), by further taking into consideration the operability, costs, etc., it is noted that a combination with a semiconductor laser single beam exposure device of an internal drum system is the most preferable.

Furthermore, for the purpose of enhancing the probability of the photopolymerization type photosensitive layer in the course after image exposure with conventional known active rays until the development, by providing a heating process at a temperature of from 50 °C to 150 °C for a period of time of from one second to 5 minutes, it is possible to enhance hardening properties of a non-image area and further enhancing printing resistance, and therefore, such is preferable.

Furthermore, the thus developed photosensitive lithographic printing plate is subjected to post treatments by using washing water, a rinse liquid containing a surfactant, etc., and a desensitizing liquid containing gum arabic, a starch derivative, etc. as described in JP-A-54-8002, JP-A-55-115045, and JP-A-59-58431. In the invention, for the post treatments of the photosensitive lithographic printing plate, a combination of a variety of these treatments can be employed.

The lithographic printing plate as obtained by these treatments is set in an offset printing machine and provided for printing of a number of sheets.

It is possible to develop the foregoing photosensitive lithographic printing plate with a conventionally known developing solution to form an image. Examples of such a conventionally known developing solution include ones as described in JP-B-57-7427. Suitable examples thereof include aqueous solutions of an inorganic alkaline agent (for example, sodium silicate, potassium silicate, sodium hydroxide, potassium hydroxide, lithium hydroxide, sodium triphosphate, sodium diphosphate, ammonium triphosphate, ammonium diphosphate, sodium metasilicate, sodium bicarbonate, and ammonia water) and aqueous solutions of an organic alkaline agent (for example, monoethanolamine and diethanolamine). A concentration of the alkaline solute of the developing solution is in general from 0.1 to 10 % by weight, and preferably from 0.5 to 5 % by weight.

Furthermore, such an alkaline aqueous solution can contain a small amount of a surfactant or an organic solvent (for example, benzyl alcohol, 2-phenoxyethanol, and 2-butoxyethanol) as the need arises. For example, there can be enumerated ones as described in U.S. Patents Nos. 3,375,171 and 3,615,480. Moreover, developing solutions as described in JP-A-50-26601, JP-A-58-54341, JP-B-56-39464, and JP-B-56-42860 can also be enumerated.

Incidentally, as the developing solution which is used for plate making of the photosensitive lithographic printing plate of the invention, an alkaline developing solution containing a polyoxyalkylene ether group-containing nonionic surfactant and having a pH of from 10.5 to 13.5 (more preferably from 11.0 to 12.5) is preferable in view of the foregoing deterioration regarding deletion of halftone dots and fine lines in the solid area.

By containing a polyoxyalkylene ether group-containing nonionic surfactant, it becomes possible to promote dissolution of the photosensitive layer in an unexposed area and to reduce penetration of the developing solution into an exposed area. As the polyoxyalkylene ether group-containing surfactant, ones having a structure represented by the following general formula (B) are suitably used.

$$R^3\text{-O-}(R^4\text{-O})_qH \qquad (B)$$

In the foregoing general formula (B), $R^3$ represents an optionally substituted alkyl group having from 3 to 15 carbon atoms, an optionally substituted aromatic hydrocarbon group having from 6 to 15 carbon atoms, or an optionally substituted heteroaromatic ring group having from 4 to 15 carbon atoms (incidentally, examples of the substituent include an alkyl group having from 1 to 20 carbon atoms, a halogen atom (for example, Br, Cl, and I), an aromatic hydrocarbon group having from 6 to 15 carbon atoms, an aralkyl group having from 7 to 17 carbon atoms, an alkoxy group having from 1 to 20 carbon atoms, an alkoxycarbonyl group having from 2 to 20 carbon atoms, and an acyl group having from 2 to 15 carbon atoms); $R^4$ represents an optionally substituted alkylene group having from 1 to 100 carbon atoms (incidentally, examples of the substituent include an alkyl group having from 1 to 20 carbon atoms and an aromatic hydrocarbon group having from 6 to 15 carbon atoms) ; and g represents an integer of from 1 to 100.

In the definition of the foregoing general formula (B), specific examples of the "aromatic hydrocarbon group" include a phenyl group, a tolyl group, a naphthyl group, an anthryl group, a biphenyl group, and a phenanthryl group;

and specific examples of the "heteroaromatic ring group" include a furyl group, a thienyl group, an oxazolyl group, an imidazolyl group, a pyranyl group, a pyridinyl group, an acridinyl group, a benzofuranyl group, a benzothienyl group, a benzopyranyl group, a benzoxazolyl group, and a benzimidazolyl group.

Furthermore, the $(R^4\text{-}O)_q$ moiety of the general formula (B) may be a combination of two or three kinds of groups so far as it falls within the foregoing range. Specifically, there are enumerated random or block-like forms of a combination, for example, a combination of an ethyleneoxy group and a propyleneoxy group, a combination of an ethyleneoxy group and an isopropyloxy group, a combination of an ethyleneoxy group and a butyleneoxy group, and a combination of an ethyleneoxy group and an isobutylene group. In the invention, the polyoxyalkylene ether group-containing surfactant is used singly or in a composite system. When the amount of addition of the polyoxyalkylene ether group-containing surfactant is 1 % by weight or more in the developing solution, it is possible to secure developability, and when it is not more than 30 % by weight, it is possible to prevent the development from damaging. The amount of addition of the polyoxyalkylene ether group-containing surfactant is preferably from 2 to 20 % by weight.

Furthermore, examples of the polyoxyalkylene ether group-containing nonionic surface represented by the foregoing general formula (B) include polyoxyethylene alkyl ethers (for example, polyoxyethylene lauryl ether, polyoxyethylene cetyl ether, and polyoxyethylene stearyl ether), polyoxyethylene aryl ethers (for example, polyoxyethylene phenyl ether and polyoxyethylene naphthyl ether), and polyoxyethylene alkylaryl ethers (for example, polyoxyethylene methylphenyl ether, polyoxyethylene octylphenyl ether, and polyoxyethylene nonylphenyl ether).

In addition, other surfactants as described below may be added. Examples of other surfactants include nonionic surfactants such as polyoxyethylene alkyl esters (for example, polyoxyethylene stearate), sorbitan alkyl esters (for example, sorbitan monolaurate, sorbitan monostearate, sorbitan distearate, sorbitan monooleate, sorbitan sesquioleate, and sorbitan trioleate), and monoglyceride alkyl esters (for example, glycerol monostearate and glycerol monooleate); anionic surfactants such as alkylbenzenesulfonic acid salts (for example, sodium dodecylbenzenesulfonate), alkylnaphthalenesulfonic acid salts (for example, sodium butylnaphthalenesulfonate, sodium pentylnaphthalenesulfonate, sodium hexylnaphthalenesulfonate, and sodium octylnaphthalenesulfonate), alkylsulfuric acid salts (for example, sodium laurylsulfate), alkylsulfonic acid salts (for example, sodium dodecylsulfonate), and sulfosuccinic acid ester salts (for example, sodium dilaurylsulfosuccinate); and ampholytic surfactants such as alkyl betaines (for example, lauryl betaine and stearyl betaine) and amino acids. Of these, anionic surfactants such as alkylnaphthalenesulfonic acid salts are especially preferable.

The surfactant can be used singly or in combination. Furthermore, the content of the surfactant in the developing solution is suitably in the range of from 2 to 20 % by weight as reduced into an active ingredient.

This alkaline developing solution usually contains an inorganic alkaline salt. The inorganic alkaline salt can be properly chosen. Examples thereof include inorganic alkaline agents such as sodium hydroxide, potassium hydroxide, ammonium hydroxide, lithium hydroxide, sodium silicate, potassium silicate, ammonium silicate, lithium silicate, sodium triphosphate, potassium triphosphate, ammonium triphosphate, sodium carbonate, potassium carbonate, ammonium carbonate, sodium hydrogencarbonate, potassium hydrogencarbonate, ammonium hydrogencarbonate, sodium borate, potassium borate, and ammonium borate. These inorganic alkaline agents may be used singly or in combination of two or more kinds thereof.

In the case where a silicate is used, it is possible to easily regulate developability by regulating a mixing ratio and concentration of silicon oxide $SiO_2$ as a component of the silicate and an alkaline oxide $M_2O$ (wherein M represents an alkali metal or an ammonium group). Among the foregoing alkaline aqueous solutions, ones having a mixing ratio of the foregoing silicon oxide $SiO_2$ and the alkaline oxide $M_2O$ (a molar ratio of $SiO_2/M_2O$) of from 0.5 to 3.0 are preferable, and ones having the subject mixing ratio of from 1.0 to 2.0 are more preferable. When the $SiO_2/M_2O$ ratio is less than 0.5, the concentration of the silicate is preferably from 1 to 10 % by weight, more preferably from 3 to 8 % by weight, and most preferably from 4 to 7 % by weight based on the weight of the alkaline aqueous solution. When this concentration is less than 1 % by weight, the developability and treatment ability may possibly be lowered, while when it exceeds 10 % by weight, precipitation or crystallization is liable to occur, and gelation is liable to occur during neutralization at the time of discharging a waste liquid so that the treatment of waste liquid may possibly be impaired.

Furthermore, for the purposes of finely adjusting the alkaline concentration and assisting the solubility of the photosensitive layer, an organic alkaline agent may be auxiliarily used jointly. Examples of the organic alkaline agent which can be used include monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, and tetramethylammonium hydroxide. These alkaline agents are used singly or in combination of two or more kinds thereof.

Furthermore, it is preferable that the developing solution which is used in the invention has a conductivity of from 3 to 30 mS/cm. When the conductivity is lower than the foregoing range, elution of the photosensitive composition on the surface of the aluminum plate support usually becomes difficult so that staining is caused during printing. Conversely, when the conductivity exceeds the foregoing range, since the salt concentration is high, an elution rate of the photosensitive layer becomes extremely low, and a residual film may possibly be generated in an unexposed area. The

conductivity is especially preferably in the range of from 5 to 20 mS/cm.

EXAMPLES

The invention will be hereunder described in detail with reference to the following Examples, but it should not be construed that the invention is limited thereto.

[Examples 1 to 5 and Comparative Examples 1 to 4]

(Preparation method of aluminum support)

An aluminum plate having a thickness of 0.3 mm was dipped in and etched with 10 % by weight sodium hydroxide at 60 °C for 25 seconds, washed with running water, neutralized and washed with 20 % by weight nitric acid, and then washed with water. The aluminum plate was subjected to an electrolytic roughing treatment in a quantity of electricity at the time of anode of 300 coulombs/$dm^2$ in a 1 % by weight nitric acid aqueous solution using an alternating waveform current of sine wave.

Subsequently, the resulting aluminum plate was dipped in a 1 % by weight sodium hydroxide aqueous solution at 40 °C for 5 seconds and then dipped in a 30 % by weight sulfuric acid aqueous solution, subjected to desmutting at 60 °C for 40 seconds, and then subjected to an anodic oxidation treatment in a 20 % by weight sulfuric acid aqueous solution at a current density of 2 A/$dm^2$ for 2 minutes such that an anodically oxidized film had a thickness of 2.7 g/$m^2$. A surface roughness thereof was measured and found to be 0.3 μm (in terms of an Ra expression according to JIS B0601).

[Application of undercoat layer]

Next, a coating liquid for applying an undercoat layer having the following composition was coated on the aluminum support by using a wire bar and then dried at 90 °C for 30 seconds by using a warm air type drying unit. The coverage after drying was 10 mg/$m^2$.

(Coating liquid for applying an undercoat layer)

- Copolymer of ethyl methacrylate and sodium 2-acrylamide-2-methyl-1-propanesulfonate (molar ratio: 75/25) (molecular weight: 18,000): 0.1 g
- Methanol: 50 g
- Ion-exchanged water: 50 g

[Application of photosensitive layer]

On the foregoing undercoat layer, a coating liquid for photosensitive layer having the following composition was prepared and coated in a thickness after drying of 0.15 g/$m^2$ by using a wheeler, followed by drying at 100 °C for one minute.

(Coating liquid for photosensitive layer)

- Ethylenically unsaturated bond-containing compound: Compound and addition amount as described in Table 1
- Binder having the following structure: 1.8 g

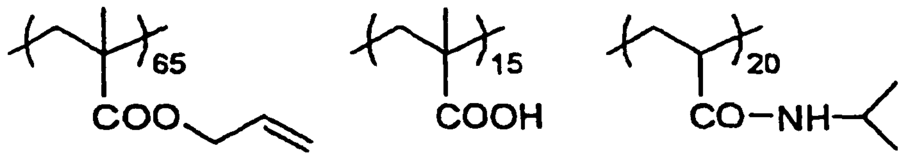

Mw: 150,000

- Sensitizing dye (compound of Table 1): 0.1 g
- Polymerization initiator having the following structure: 0.15 g

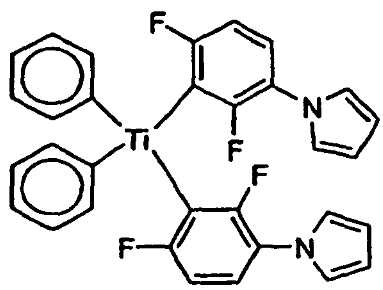

- Sensitizing assistant having the following structure: 0.2 g

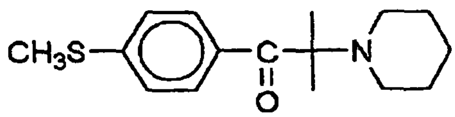

- Coloring pigment dispersion having the following composition: 1.5 g
- Thermal polymerization inhibitor (N-nitrosophenylhydroxylamine): 0.01 g
- Surfactant (MEGAFAC F176 as manufactured by Dainippon Ink and Chemicals, Incorporated): 0.02 g
- Methyl ethyl ketone: 20.0 g
- Propylene glycol monomethyl ether: 20.0 g

<Composition of coloring pigment dispersion>

- Pigment Blue 15:6: 15 parts by weight
- Allyl methacrylate/methacrylic acid 10 parts by weight copolymer (copolymerization molar ratio: 83/17) as thermally polymerized:
- Cyclohexanone: 15 parts by weight
- Methoxypropyl acetate: 20 parts by weight
- Propylene glycol monomethyl ether: 40 parts by weight

[Application of protective layer]

On this photosensitive layer, a coating liquid for protective layer having the following composition was coated in a coating weight after drying of 2 g/$m^2$, followed by drying at 100 °C for 2 minutes.

<Composition of coating liquid for protective layer>

- Polyvinyl alcohol (degree of hydrolysis: 98 % by mole, degree of polymerization: 550): 4 g
- Polyvinylpyrrolidone (molecular weight: 100,000) 1 g
- Water: 95 g

Each of the thus obtained photosensitive lithographic printing plates was subjected to plate making and then evaluation for sensitivity and printing resistance in the following manners.

(Exposure)

With respect to Examples 1 to 3 and Comparative Examples 1 and 2,, an internal drum type experimental unit mounted with a 100-mW FD-YAG laser (532 nm) was used; the quantity of light was adjusted such that it was 0.2 $mJ/cm^2$; and a gray scale was stuck on the surface of the printing plate and exposed from above under a condition at a drum temperature of 15 °C and 30 °C, respectively. The gray scale is prepared such that the quantity of light is changed by every $1/\sqrt{2}$. It is meant that the higher the number of steps of the gray scale, the higher the sensitivity is. A GAFT chart of from 1 to 99 % of halftone dots (200 lines) was exposed at the same time.

With respect to Examples 4 and 5 and Comparative Examples 1 and 2, an internal drum type experimental unit mounted with a 30-mW violet laser (405 nm) was used; the quantity of light was adjusted such that it was 0.1 $mJ/cm^2$; and exposure was carried out in the same manner.

(Development/plate making)

In an automatic processor LP-850P2 (pre-heating temperature: 100 °C) as manufactured by Fuji Photo Film Co., Ltd., the following developing solution and a finisher FP-2W as manufactured by Fuji Photo Film Co., Ltd. were charged, respectively, and the exposed plate was subjected to development/plate making under a condition at a temperature of developing solution of 30 °C for a development time of 18 seconds, to obtain a lithographic printing plate.

(Aqueous solution having the following composition and having a pH of 11.6)

- Sodium hydroxide: 0.15 parts by weight
- Compound having the following 5.0 parts by weight structure:
- Tetrasoium ethylenediaminetetra- 0.1 parts by weight acetate:
- Water: 94.75 parts by weight

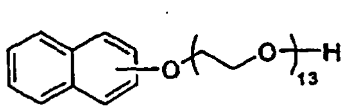

Measurement of the sensitivity was carried out under the foregoing conditions.

Evaluation of the small dot adhesion was carried out by enlarging an image of the small dot portion of the GAFT chart by using a loupe and examining the minimum halftone dot remaining as a sharp dot.

A rate of area on the plate of a 50 %-input screen was also measured.

The results obtained are shown in Table 1.

Table 1

| | Ethylenically unsaturated bond-containing compound | | Sensitizing dye | Drum temperature:15 °C | | | Drum temperature: 30 °C | | | Influence (difference) of drum temperature | |
|---|---|---|---|---|---|---|---|---|---|---|---|
| | | | | Sensitivity (number of steps on G/S) | Small dot adhesion (%) | Rate of area of 50% halftone dot | Sensitivity (number of steps on G/S) | Small dot adhesion (%) | Rate of area of 50% halftone dot | Sensitivity (number of steps on G/S) | Rate of area of 50% halftone dot |
| Example 1 | a-3 | 2 g | S-1 | 7.0 | 1 | 64 | 7.3 | 1 | 65 | 0.3 | 1 |
| Example 2 | a-6 | 2 g | S-1 | 7.5 | 1 | 65 | 7.5 | 1 | 66 | 0.0 | 1 |
| Example 3 | a-10<br>PET4A | 1g<br>1g | S-1 | 6.8 | 2 | 63 | 7.0 | 1 | 63 | 0.2 | 0 |
| Example 4 | a-6 | 2 g | S-2 | 6.8 | 1 | 62 | 6.8 | 1 | 62 | 0.0 | 0 |
| Example 5 | a-19<br>U-1 | 1 g<br>1 g | S-2 | 7.0 | 1 | 62 | 7.0 | 1 | 63 | 0.0 | 1 |
| Example 6 | a-19 | 2 g | S-3 | 6.0 | 1 | 60 | 6.0 | 1 | 60 | 0.0 | 0 |
| Example 7 | a-10<br>TMP3MA | 1 g<br>1 g | S-4 | 6.8 | 1 | 62 | 6.8 | 1 | 61 | 0.0 | 1 |
| Comparative Example 1 | PET4A | 2 g | S-1 | 5.0 | 3 | 58 | 7.5 | 2 | 65 | 2.5 | 7 |
| Comparative Example 2 | TMP3MA | 2 g | S-1 | 4.0 | 4 | 55 | 6.0 | 2 | 60 | 2.0 | 5 |
| Comparative Example 3 | PET4A | 2 g | S-2 | 5.0 | 3 | 57 | 7.0 | 1 | 65 | 2.0 | 8 |
| Comparative Example 4 | TMP3MA | 2 g | S-2 | 4.0 | 2 | 54 | 6.0 | 1 | 61 | 2.0 | 7 |
| Comparative Example 5 | U-1 | 2 g | S-3 | 4.3 | 3 | 55 | 7.3 | 2 | 63 | 3.0 | 8 |
| Comparative Example 6 | U.1 | 2 g | S-4 | 4.0 | 3 | 53 | 7.3 | 1 | 62 | 3.3 | 9 |

The abbreviations in Table 1 will be summarized and described below.

(Ethylenically unsaturated bond-containing compound)

PET4A: Pentaerythritol tetraacrylate
TMP3A: Trimethylolpropane triacrylate
TMP3MA: Trimethylolpropane trimethacrylate
U-1: Compound having the following structure

(U-1)

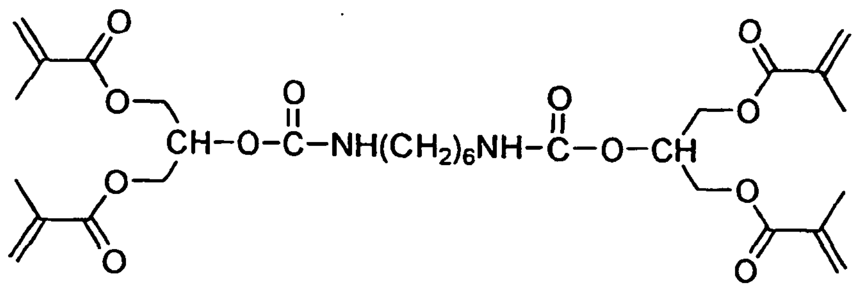

(Sensitizing dye)

(S-1)

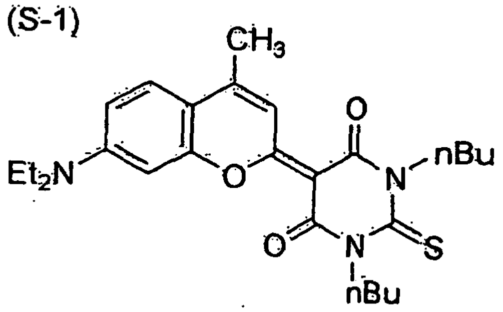

(S-2)

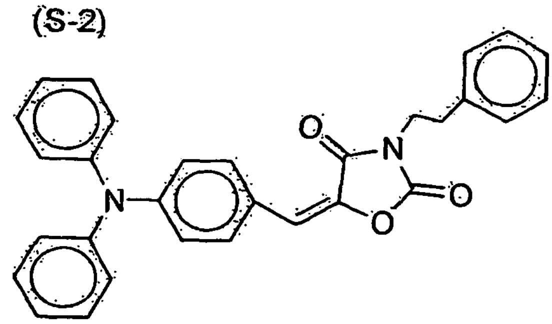

(S-3)

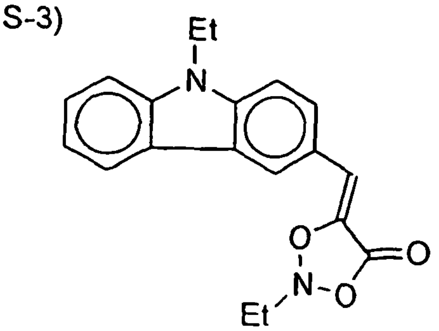

(S-4)

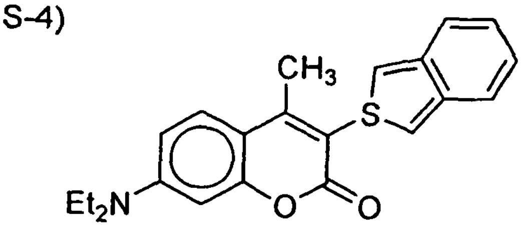

[Examples 6 and 7 and Comparative Examples 5 to 6]

(Preparation method of aluminum support)

The surface of an aluminum plate (material quality: 1S) having a thickness of 0.30 mm was subjected to graining by using a No. 8 nylon brush and an aqueous suspension of 800-mesh pamiston and then thoroughly washed with water. The resulting aluminum plate was dipped in and etched with 10 % by weight sodium hydroxide at 70 °C for 60 seconds, washed with running water, neutralized and washed with 20 % by weight $HNO_3$, and then washed with water. The aluminum plate was subjected to an electrolytic roughing treatment in a quantity of electricity at the time of anode of 300 coulombs/$dm^2$ in a 1 % by weight nitric acid aqueous solution using an alternating waveform current of sine wave under a condition at a VA of 12.7 V. A surface roughness thereof was measured and found to be 0.45 μm (in terms of an Ra expression). Subsequently, the resulting aluminum plate was dipped in a 30 % $H_2SO_4$ aqueous solution, subjected to desmutting at 55 °C for 2 minutes, and then subjected to anodic oxidation in a 20 % $H_2SO_4$ aqueous solution at a current density of 5 A/$dm^2$ for 50 seconds while disposing a cathode on the grained surface. As a result, an anodically oxidized film had a thickness of 2.7 g/$m^2$.

[Application of undercoat layer]

Next, a coating liquid for applying an undercoat layer having the following composition was coated on the aluminum support by using a wire bar and then dried at 90 °C for 30 seconds by using a warm air type drying unit. The coverage after drying was 10 mg/$m^2$.

(Coating liquid for applying an undercoat layer)

- Methanol: 90 g
- Pure water: 10 g
- Compound having the following structure: 0.01 g

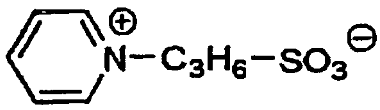

[Application of photosensitive layer]

On the foregoing undercoat layer, a coating liquid for photosensitive layer having the following composition was prepared and coated in a thickness after drying of 0.15 g/$m^2$ by using a wheeler, followed by drying at 120 °C for 2 minutes.

(Coating liquid for photosensitive layer (photopolymerizable composition))

- Ethylenically unsaturated bond-containing compound: Compound and addition amount as described in Table 1
- Binder (resulting from changing the binder of Example 1 to one having the following structure):
- Urethane resin having the following structure: 1.5 g

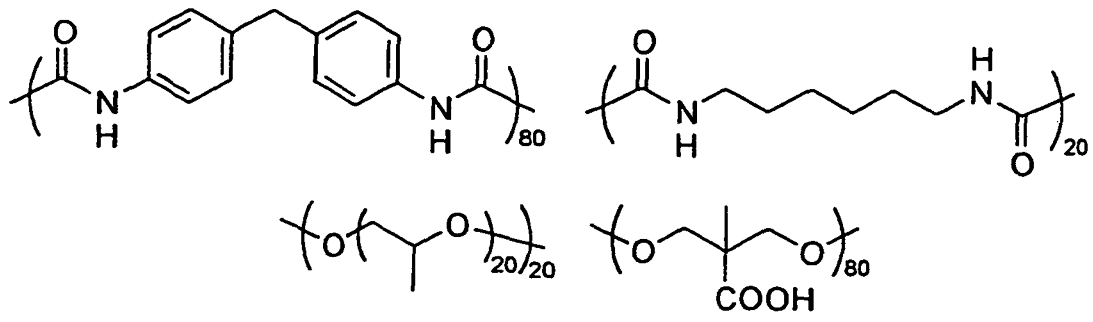

- Sensitizing dye (compound of Table 1): 0.1 g
- Components of coating liquid for photosensitive layer other than the foregoing compounds (the same as in Example 1):

The application of protective layer, the plate making and the evaluation were carried out in manners exactly the same as in Example 1. With respect to Example 6 and Comparative Example 5, the exposure was carried out by using a 30-mW violet laser, and with respect to Example 7 and Comparative Example 6, the exposure was carried out by using a 100-mW FD-YAG laser.

The results obtained are shown in Table 1.

It is evident from Table 1 that the Examples according to the invention are low in temperature dependency with respect to the sensitivity and halftone dot area and have a characteristic of high sensitivity as compared with the Comparative Examples.

This application is based on Japanese Patent application JP 2004-248622, filed August 27, 2004.

## Claims

1. A photosensitive lithographic printing plate comprising an aluminum substrate subjected to a roughing treatment and a photopolymerizable photosensitive layer, wherein the photopolymerizable photosensitive layer contains a compound having three or more ethylenically unsaturated double bonds and containing 4 to 12 structural units selected from an ethyleneoxy structural unit and a propyleneoxy structural unit in one molecule thereof, an alkali-soluble or swelling binder, and a photo-polymerization initiator.

2. The photosensitive lithographic printing plate according to claim 1, wherein the photopolymerizable photosensitive layer further contains a compound selected from acrylates and methacrylates each containing three or more ethylenically unsaturated groups in one molecule thereof and having a molecular weight of not more than 800.

3. The photosensitive lithographic printing plate according to claim 1, wherein the alkali-soluble or swelling binder having a radical reactive group in a side chain thereof.

4. The photosensitive lithographic printing plate according to claim 2, wherein the alkali-soluble or swelling binder having a radical reactive group in a side chain thereof.

5. The photosensitive lithographic printing plate according to claim 1, further comprising a protective layer containing a water-soluble high molecular compound, so that the support, the photopolymerizable photosensitive layer and the protective layer are provided in this order.

6. The photosensitive lithographic printing plate according to claim 1, wherein the compound has from 3 to 8 ethylenically unsaturated double bonds.

7. The photosensitive lithographic printing plate according to claim 1, wherein the compound contains from 4 to 12 structural units selected from an ethyleneoxy structural unit and a propyleneoxy structural unit in one molecule thereof.

8. The photosensitive lithographic printing plate according to claim 1, wherein the alkali-soluble or swelling binder has a weight average molecular weight of from 5,000 to 300,000.

9. The photosensitive lithographic printing plate according to claim 1, wherein the alkali-soluble or swelling binder has an acid value of from 20 to 200 meq/g.

10. The photosensitive lithographic printing plate according to claim 1, wherein the photopolymerization initiator is a titanocene compound.

11. The photosensitive lithographic printing plate according to claim 1, wherein the binder is a urethane based binder.

**Patentansprüche**

1. Fotoempfindliche Lithografiedruckplatte, umfassend ein Aluminiumsubstrat, das einer Aufrauungsbehandlung unterzogen worden ist, und eine fotopolymerisierbare, fotoempfindliche Schicht, worin die fotopolymerisierbare, fotoempfindliche Schicht eine Verbindung, die drei oder mehr enthylenisch ungesättigte Doppelbindungen aufweist und die 4 bis 12 Struktureinheiten, ausgewählt aus einer Ethylenoxy-Struktureinheit und einer Propylenoxy-Struktureinheit, in einem Molekül hiervon enthält, ein Alkali-lösliches oder quellendes Bindemittel und einen Fotopolymerisationsinitiator umfasst.

2. Fotoempfindliche Lithografiedruckplatte gemäß Anspruch 1, worin die fotopolymerisierbare, fotoempfindliche Schicht ferner eine Verbindung umfasst, ausgewählt aus Acrylaten und Methacrylaten, die jeweils drei oder mehr ethylenisch ungesättigte Gruppen in einem Molekül hiervon enthalten und die ein Molekulargewicht von nicht größer als 800 aufweisen.

3. Fotoempfindliche Lithografiedruckplatte gemäß Anspruch 1, worin das Alkali-lösliche oder quellende Bindemittel eine radikal-reaktive Gruppe in einer Seitenkette hiervon aufweist.

4. Fotoempfindliche Lithografiedruckplatte gemäß Anspruch 2, worin das Alkali-lösliche oder quellende Bindemittel eine radikal-reaktive Gruppe in einer Seitenkette hiervon aufweist.

5. Fotoempfindliche Lithografiedruckplatte gemäß Anspruch 1, ferner umfassend eine Schutzschicht, die eine wasserlösliche, hoch-molekulare Verbindung enthält, so dass der Träger, die fotopolymerisierbare, fotoempfindliche Schicht und die Schutzschicht in dieser Reihenfolge vorgesehen sind.

6. Fotoempfindliche Lithografiedruckplatte gemäß Anspruch 1, worin die Verbindung 3 bis 8 ethylenisch ungesättigte Doppelbindungen aufweist.

7. Fotoempfindliche Lithografiedruckplatte gemäß Anspruch 1, worin die Verbindung 4 bis 12 Struktureinheiten, ausgewählt aus einer Ethylenoxy-Struktureinheit und einer Propylenoxy-Struktureinheit, in einem Molekül hiervon enthält.

8. Fotoempfindliche Lithografiedruckplatte gemäß Anspruch 1, worin das Alkali-lösliche oder quellende Bindemittel ein gewichtsgemitteltes Molekulargewicht von 5.000 bis 300.000 aufweist.

9. Fotoempfindliche Lithografiedruckplatte gemäß Anspruch 1, worin das Alkali-lösliche oder quellende Bindemittel einen Säurewert von 20 bis 200 meq/g aufweist.

10. Fotoempfindliche Lithografiedruckplatte gemäß Anspruch 1, worin der Fotopolymerisationsinitiator eine Titanocenverbindung ist.

11. Fotoempfindliche Lithografiedruckplatte gemäß Anspruch 1, worin das Bindemittel ein Bindemittel auf Urethanbasis ist.

**Revendications**

1. Plaque d'impression lithographique photosensible comprenant un substrat d'aluminium soumis à un traitement de dégrossissage et une couche photosensible photopolymérisable, dans laquelle la couche photosensible photopolymérisable contient un composé ayant trois liaisons doubles ou plus éthyléniquement insaturées et contenant 4 à

12 unités structurales choisies parmi une unité structurale éthylèneoxy et une unité structurale propylèneoxy dans une molécule de celui-ci, un liant soluble ou gonflant dans l'alcali, et un initiateur de photopolymérisation.

**2.** Plaque d'impression lithographique photosensible selon la revendication 1, dans laquelle la couche photosensible photopolymérisable contient en outre un composé choisi parmi des acrylates et des méthacrylates contenant chacun trois groupes ou plus éthyléniquement insaturés dans une molécule de celui-ci et ayant un poids moléculaire de pas plus de 800.

**3.** Plaque d'impression lithographique photosensible selon la revendication 1, dans laquelle le liant soluble ou gonflant dans l'alcali a un groupe réactif radicalaire dans une chaîne latérale de celui-ci.

**4.** Plaque d'impression lithographique photosensible selon la revendication 2, dans laquelle le liant soluble ou gonflant dans l'alcali a un groupe réactif radicalaire dans une chaîne latérale de celui-ci.

**5.** Plaque d'impression lithographique photosensible selon la revendication 1, comprenant en outre une couche protectrice contenant un composé de poids moléculaire élevé soluble dans l'eau, de telle sorte que le support, la couche photosensible photopolymérisable et la couche protectrice sont disposés dans cet ordre.

**6.** Plaque d'impression lithographique photosensible selon la revendication 1, dans laquelle le composé a de 3 à 8 liaisons doubles éthyléniquement insaturées.

**7.** Plaque d'impression lithographique photosensible selon la revendication 1, dans laquelle le composé contient de 4 à 12 unités structurales choisies parmi une unité structurale éthylèneoxy et une unité structurale propylèneoxy dans une molécule de celui-ci.

**8.** Plaque d'impression lithographique photosensible selon la revendication 1, dans laquelle le liant soluble ou gonflant dans l'alcali a un poids moléculaire moyen en poids de 5 000 à 300 000.

**9.** Plaque d'impression lithographique photosensible selon la revendication 1, dans laquelle le liant soluble ou gonflant dans l'alcali a un indice d'acide de 20 à 200 meq/g.

**10.** Plaque d'impression lithographique photosensible selon la revendication 1, dans laquelle l'initiateur de photopolymérisation est un composé titanocène.

**11.** Plaque d'impression lithographique photosensible selon la revendication 1, dans laquelle le liant est un liant à base d'uréthane.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 9268185 A
- JP 10204085 A
- JP 9080750 A
- JP 2001042524 A
- JP 48018327 B
- JP 56028893 A
- JP 53012739 A
- JP 48028123 B
- JP 7159983 A
- US 3055295 A
- JP 56013168 A
- JP 9080744 A
- JP 8507727 T
- JP 59101651 A
- JP 2003021908 A
- JP 48041708 B
- JP 51037193 A
- JP 2032293 B
- JP 48064183 A
- JP 49043191 B
- JP 52030490 B
- JP 59044615 A
- JP 54034327 B
- JP 58012577 B
- JP 54025957 B
- JP 54092723 A
- JP 59053836 A
- JP 59071048 A
- JP 7120040 B
- JP 7120041 B
- JP 7120042 B
- JP 8012424 B
- JP 63287944 A
- JP 63287947 A
- JP 1271741 A
- JP 10116232 A
- JP 11352691 A
- JP 2001228608 A
- JP 2002174907 A
- JP 2003270775 A
- JP 2003270776 A
- US 2850445 A
- JP 4420189 B
- JP 4537377 B
- JP 47002528 B
- JP 54155292 A
- JP 48084183 A
- JP 54151024 A
- JP 52112681 A
- JP 58015503 A
- JP 59140203 A
- JP 59001504 A
- JP 59189340 A
- JP 62174203 A
- JP 62001641 B
- US 4766055 A
- JP 63258903 A
- JP 2063054 A
- JP 62143044 A
- JP 62150242 A
- JP 6413140 A
- JP 6413141 A
- JP 6413142 A
- JP 6413143 A
- JP 6413144 A
- JP 6417048 A
- JP 1229003 A
- JP 1298348 A
- JP 1138204 A
- JP 2179643 A
- JP 2244050 A
- JP 63221110 A
- JP 4221958 A
- JP 4219756 A
- JP 6295061 A
- JP 8334897 A
- JP 11084647 A
- JP 2000147763 A
- JP 59152396 A
- JP 61151197 A
- US 3458311 A
- JP 55049729 A
- JP 54008002 A
- JP 55115045 A
- JP 59058431 A
- JP 57007427 B
- US 3375171 A
- US 3615480 A
- JP 50026601 A
- JP 58054341 A
- JP 56039464 B
- JP 56042860 B
- JP 2004248622 A